# EUROPEAN PATENT APPLICATION

(11) **EP 4 543 154 A1**
(43) Date of publication of application: **23.04.2025**
(21) Application number: 23838831.8
(22) Date of filing: 06.07.2023
(51) Int. Cl.: H05K 7/20, G06F 1/20

(54) **ELECTRONIC ASSEMBLY AND ELECTRONIC DEVICE**

(30) Priority: 15.07.2022 CN 202210832986
(71) Applicant: Huawei Technologies Co., Ltd., Shenzhen, Guangdong 518129 (CN)
(72) Inventor: LI, Dingfang, Shenzhen, Guangdong 518129 (CN); LI, Min, Shenzhen, Guangdong 518129 (CN); YU, Fei, Shenzhen, Guangdong 518129 (CN); BAI, Lu, Shenzhen, Guangdong 518129 (CN)
(74) Representative: Pfenning, Meinig & Partner mbB
(86) International application number: PCT/CN2023/106055
(87) International publication number: WO 2024/012339

(57) **Abstract**

This application provides an electronic assembly, including a first heat dissipation panel, a second heat dissipation panel, and a first circuit board assembly. The first heat dissipation panel is provided with a runner. The second heat dissipation panel is fastened to the first heat dissipation panel, and encloses a working medium cavity with the first heat dissipation panel, where the working medium cavity is in communication with the runner. The first circuit board assembly includes a first circuit board, a first component, and a second component, the first component and the second component are both disposed on a same side of the first circuit board, the first circuit board and the first heat dissipation panel are disposed in a stacked manner, the first component is connected to the first heat dissipation panel, and the second component is connected to the second heat dissipation panel. This application further provides an electronic device, including a working medium and the electronic assembly, where the working medium flows in the runner and the working medium cavity of the electronic assembly. According to the solutions of this application, efficient heat dissipation can be implemented, and reliability and experience of a product can be improved.

## Description

This application claims priority to Chinese Patent Application No. 202210832986.3, filed with the China National Intellectual Property Administration on July 15, 2022 and entitled "ELECTRONIC ASSEMBLY AND ELECTRONIC DEVICE", which is incorporated herein by reference in its entirety.

### TECHNICAL FIELD

This application relates to the field of electronic products, and in particular, to an electronic assembly and an electronic device.

### BACKGROUND

With development of information technologies, an integration level of a chip on a circuit board of an electronic device is increasingly high, and power consumption of the chip is also increasing, which impose a higher requirement on heat dissipation of the chip. However, an existing product heat dissipation solution cannot implement effective heat dissipation, affecting reliability and experience of a product.

### SUMMARY

This application provides an electronic assembly and an electronic device, to implement efficient heat dissipation and improve reliability and experience of a product.

According to a first aspect, this application provides an electronic assembly, including a first heat dissipation panel, a second heat dissipation panel, and a first circuit board assembly. The first heat dissipation panel is provided with a runner. The second heat dissipation panel is fastened to the first heat dissipation panel, and encloses a working medium cavity with the first heat dissipation panel, where the working medium cavity is in communication with the runner. The first circuit board assembly includes a first circuit board, a first component, and a second component, and the first component and the second component are both disposed on a same side of the first circuit board. The first circuit board and the first heat dissipation panel are disposed in a stacked manner, the first component is connected to the first heat dissipation panel, and the second component is connected to the second heat dissipation panel.

In the electronic assembly provided in this application, an entire surface that is of the second heat dissipation panel and that is connected to the second component may be used for heat exchange. The first heat dissipation panel and the second heat dissipation panel respectively perform heat dissipation processing on the first component and the second component of the circuit board assembly, and different heat dissipation panels are disposed for different heat dissipation requirements of the first component and the second component, so that functions of the first heat dissipation panel and the second heat dissipation panel can be utilized to the greatest extent, effective heat dissipation of the electronic assembly can be ensured, and therefore reliability and experience of a product can be improved.

In an implementation of the first aspect, the runner is embedded inside the first heat dissipation panel. In this implementation, the first heat dissipation panel has a simple structure, and the runner may be obtained through drilling. Therefore, mass production performance is good, and a heat dissipation module has a reliable structure, so that good heat dissipation effect can be ensured.

In an implementation of the first aspect, the first heat dissipation panel includes a substrate and a cover plate, a surface of the substrate is provided with a runner groove, the cover plate is connected to a side that is of the substrate and that is provided with the runner groove, and the cover plate covers the substrate and seals the runner groove to form the runner. A processing manner of the runner in this implementation is simple and processing difficulty is low. The runner groove only needs to be processed on the surface of the substrate in a milling manner or another manner, and the runner groove and the cover plate may cooperate to form the runner. There are many processing manners that can be selected to process the runner groove, and a degree of freedom and flexibility of a shape of the runner groove are also very high. Therefore, the first heat dissipation panel in this implementation has high adaptability and scalability, and can meet requirements of more working environments.

In an implementation of the first aspect, the first heat dissipation panel includes a substrate and a runner pipe, the substrate is provided with an accommodating groove, the runner pipe is fastened to the accommodating groove, and the runner pipe is used as the runner. The runner in this implementation may be completely assembled by splicing runner pipes, so that the runner has a high degree of design freedom and high scalability and adaptability, and maintenance is easy and efficient.

In an implementation of the first aspect, the first heat dissipation panel includes a substrate and a runner pipe, a substrate runner is embedded in the substrate, the runner pipe is installed on the substrate and is in communication with the substrate runner, and the runner pipe and the substrate runner jointly form the runner. An advantage of the first heat dissipation panel in this implementation is that the first heat dissipation panel is assembled by splicing the substrate and a plurality of runner pipes, so that a shape of the first heat dissipation panel has a high degree of freedom, and the first heat dissipation panel has high scalability and adaptability. The runner pipe is used as a part of the runner. If the runner pipe of the first heat dissipation panel is damaged, there is no need to replace the entire first heat dissipation panel, and only the partial runner pipe needs to be replaced. This can greatly reduce maintenance costs and improve maintenance efficiency.

In an implementation of the first aspect, the first heat dissipation panel is provided with a mounting groove, and the mounting groove is in communication with the runner; and the second heat dissipation panel is mounted in the mounting groove, and seals an opening of the mounting groove to enclose the working medium cavity with the first heat dissipation panel. The first heat dissipation panel is provided with the mounting groove to accommodate at least a part of second heat dissipation panels, so that the second heat dissipation panel is in fastened connection to the first heat dissipation panel, and a thickness of assembling and connecting the second heat dissipation panel and the first heat dissipation panel can be reduced in a thickness direction of the first heat dissipation panel. This reduces a thickness of the electronic assembly, and is conducive to implementing lightness and thinness of the product.

In an implementation of the first aspect, the runner includes a first primary runner, a second primary runner, and a plurality of branch runners, the first primary runner and the second primary runner are arranged in parallel and are separated, each branch runner is in communication with the first primary runner and the second primary runner, the plurality of branch runners are separated, and the plurality of branch runners are connected in parallel. After the runner is split into the primary runners and the branch runners, the branch runner shares heat dissipation pressure of the primary runner, and a contact area of the working medium flowing in the runner is increased, so that the first heat dissipation panel quickly disperses heat, and heat dissipation efficiency of the first heat dissipation panel is improved. In addition, after the plurality of branch runners are connected in parallel, the branch runners do not interfere with each other. If a branch runner is damaged, only heat dissipation performance in a range of the current branch runner is affected, and heat dissipation performance of another branch runner is not affected. This can greatly improve reliability of a heat dissipation system.

In an implementation of the first aspect, the electronic assembly includes a plurality of second heat dissipation panels, and at least one branch runner is connected to at least two second heat dissipation panels in series. Each branch runner shares a part of heat load of the second heat dissipation panel, to avoid impact on working of the electronic component due to excessive heat concentration of the system, and therefore improve heat dissipation efficiency of the system. In addition, after the plurality of branch runners are connected in parallel, the branch runners do not interfere with each other. If a branch runner is damaged, only heat dissipation performance of a second heat dissipation panel on the current branch runner is affected, and a second heat dissipation panel on another branch runner is not affected. This can greatly improve reliability of the heat dissipation system and the electronic assembly.

In an implementation of the first aspect, circuit board assemblies and second heat dissipation panels are disposed on two opposite sides of the first heat dissipation panel; and in a circuit board assembly on a same side of the first heat dissipation panel, a first component is connected to the first heat dissipation panel, and a second component is connected to a second heat dissipation panel on the same side. A plurality of circuit board assemblies jointly use one first heat dissipation panel on two sides of the first heat dissipation panel to dissipate heat, to implement stacked disposition of the circuit board assemblies, and therefore ensure a high-density layout of components to meet a function requirement of the product. In this design, a structure of the electronic assembly is simple, and a total thickness of the electronic assembly is small, which are conducive to implementing lightness and thinness of an electronic device. In addition, because the second heat dissipation panels on the two sides of the first heat dissipation panel are in communication with the first heat dissipation panel, a layout of the working medium runner of the heat dissipation module is simple, so that mass production performance and reliability of the product are improved, and costs are reduced.

In an implementation of the first aspect, the electronic assembly further includes a fixing piece and an elastic piece. The fixing piece is connected to the first circuit board and the first heat dissipation panel, the elastic piece is located between the fixing piece and the first circuit board, and the elastic piece elastically abuts against both the fixing piece and the circuit board. The circuit board assembly and the first heat dissipation panel that are in floating connection with each other provide a specific installation tolerance for the circuit board assembly and the heat dissipation module. The floating connection can adaptively maintain installation pressure between the circuit board assembly and the heat dissipation module within a specific range, which can greatly avoid damage to an electronic component in an installation process, effectively improve a product yield, and reduce production and manufacturing costs.

In an implementation of the first aspect, a part of the first heat dissipation panel is hollow-out, and the second heat dissipation panel is fastened to a non-hollow-out region of the first heat dissipation panel. The substrate is a hollow-out plate structure, which can reduce consumables, a weight, and costs.

According to a second aspect, this application provides an electronic device, including a working medium and the foregoing electronic assembly, where the working medium flows in a runner and a working medium cavity. In the electronic device provided in this application, the working medium may take away heat of the electronic assembly, to maintain efficient working of the electronic assembly.

According to a third aspect, this application provides a heat dissipation module, including a first heat dissipation panel and a second heat dissipation panel. The first heat dissipation panel is provided with a runner. The second heat dissipation panel is fastened to the first heat dissipation panel, and encloses a working medium cavity with the first heat dissipation panel, where the working medium cavity is in communication with the runner.

In the heat dissipation module provided in this application, a corresponding first heat dissipation panel and a corresponding second heat dissipation panel may be separately disposed based on different heat dissipation requirements of electronic components, so that a function of the heat dissipation module can be utilized to the greatest extent, and heat dissipation efficiency of the heat dissipation module can be improved.

In an implementation of the third aspect, second heat dissipation panels are disposed on two opposite sides of the first heat dissipation panel, the second heat dissipation panels on the two sides each enclose a working medium cavity with the first heat dissipation panel, and each working medium cavity is in communication with the runner of the first heat dissipation panel.

The second heat dissipation panels are separately disposed on the two sides of the first heat dissipation panel, so that circuit board assemblies can be disposed on both sides of the heat dissipation module for heat dissipation. This solution can implement a high-density layout of components to meet a function requirement of a product. Because only one layer of first heat dissipation panel needs to be disposed, and the first heat dissipation panel and the second heat dissipation panels on the two sides of the first heat dissipation panel are used to dissipate heat for components on the two sides of the first heat dissipation panel, a structure of an electronic assembly is simple, and a total thickness of the electronic assembly is small, which are conducive to implementing lightness and thinness of an electronic device. In addition, because the second heat dissipation panels on the two sides of the first heat dissipation panel are in communication with the first heat dissipation panel, a layout of the working medium runner of the heat dissipation module is simple, so that mass production performance and reliability of the product are improved, and costs are reduced.

### BRIEF DESCRIPTION OF DRAWINGS

FIG. 1 is a schematic diagram of an overall structure of an electronic assembly according to an embodiment of this application;
FIG. 2 is a schematic diagram of an exploded structure of an electronic assembly according to an embodiment of this application;
FIG. 3 is a schematic diagram of a structure of a heat dissipation module according to an embodiment of this application;
FIG. 4 is a schematic diagram of a structure of a heat dissipation module according to an embodiment of this application;
FIG. 5 is a schematic diagram of a partially enlarged structure at a position A in FIG. 4;
FIG. 6 is a partial sectional view of a heat dissipation module according to an embodiment of this application;
FIG. 7 is a schematic diagram of a structure of cooperation between a first heat dissipation module and a second heat dissipation module;
FIG. 8 is a schematic diagram of another structure of cooperation between a first heat dissipation module and a second heat dissipation module;
FIG. 9 is a schematic diagram of a structure of a heat dissipation module according to an embodiment of this application;
FIG. 10 is a schematic diagram of a structure of a heat dissipation module according to an embodiment of this application;
FIG. 11 is a schematic diagram of a structure of a heat dissipation module according to an embodiment of this application; and
FIG. 12 is a schematic diagram of a structure of cooperation between a circuit board assembly and a connecting frame according to an embodiment of this application.

### DESCRIPTION OF EMBODIMENTS

The following clearly and completely describes technical solutions in embodiments of this application with reference to accompanying drawings in embodiments of this application. Clearly, the described embodiments are some but not all of embodiments of this application. All other embodiments obtained by a person of ordinary skill in the art based on embodiments of this application without creative efforts shall fall within the protection scope of this application.

An embodiment of this application provides an electronic device, including but not limited to a mobile phone, a tablet computer, a notebook computer, a desktop computer, a wearable device (for example, a smartwatch, a smart band, smart glasses, or a smart helmet), an electronic blood pressure meter, an in-vehicle infotainment, a router, mobile Wi-Fi, a server, a storage device, a switch, a communication device, or the like.

The electronic device may include an electronic assembly and a working medium, and the working medium may flow in a runner of the electronic assembly to implement liquid cooling heat dissipation of the electronic assembly.

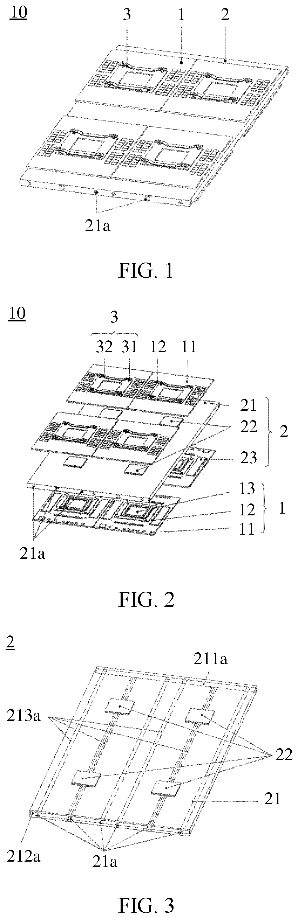

As shown in FIG. 1, the electronic assembly 10 may include a circuit board assembly 1, a heat dissipation module 2, and a connecting piece 3. The working medium may specifically flow in a runner 21a of the heat dissipation module 2, to effectively dissipate heat radiated by a heat source in the circuit board assembly 1.

As shown in FIG. 2, the circuit board assembly 1 may include a circuit board 11, a first component 12, and a second component 13. Both the first component 12 and the second component 13 are disposed on a same side of the circuit board 11. In an implementation of this application, the second component 13 may be a component with a high heat amount, for example, a master chip. The master chip may be a high-power component, for example, a central processing unit. The first component 12 may be a component with a low heat amount, for example, a low-power chip or another electronic component, for example, a voltage regulator component or a storage component. It may be understood that, another component may be further disposed on the circuit board 11 based on a requirement, and the first component 12 and the second component 13 described above are merely examples. Components may be disposed on both sides of the circuit board 11.

As shown in FIG. 2, both the first component 12 and the second component 13 generate heat during work. The heat affects performance of the first component 12 and the second component 13 and overall performance of the electronic device. Therefore, the external heat dissipation module 2 is required to dissipate heat for the first component 12 and the second component 13. There is a difference between heat amounts of the first component 12 and the second component 13, and different parts of the heat dissipation module 2 may be used to separately dissipate heat for the first component 12 and the second component 13. Heights of electronic components on the circuit board 11 are different, and different parts of the heat dissipation module 2 may be adapted to electronic components of different heights.

As shown in FIG. 2, the heat dissipation module 2 may include a first heat dissipation panel 21 and a second heat dissipation panel 22, and the first heat dissipation panel 21 is in fastened connection to the second heat dissipation panel 22. The fastened connection may be a non-detachable connection, for example, a connection through welding. Alternatively, the fastened connection may be a detachable connection, for example, a connection using a threaded connecting piece. Both the first heat dissipation panel 21 and the second heat dissipation panel 22 may be approximately plate-shaped. An area of the first heat dissipation panel 21 may be large, and an area of the second heat dissipation panel 22 may be small. For example, the second heat dissipation panel 22 may be located inside the first heat dissipation panel 21 (to be specific, within outer contour lines of the first heat dissipation panel 21).

As shown in FIG. 3, for example, the first heat dissipation panel 21 may be a temperature equalizing panel, and the runner 21a in the first heat dissipation panel 21 may be approximately linear or tubular (where the runner 21a is shown by dashed lines in FIG. 3, and the figure shows only some runners 21a but not all runners 21a). The runner 21a may be connected to an external pipeline, so that the working medium enters the runner 21a. Because a heat exchange area of the linear or tubular runner 21a is small, the first heat dissipation panel 21 may be used to dissipate heat for the first component 12. The first heat dissipation panel 21 is provided with a mounting groove (which is further described below), and the mounting groove is in communication with the runner 21a in the first heat dissipation panel 21. In this embodiment, a region in which the mounting groove is formed on the first heat dissipation panel 21 may be integrally connected to another region of the first heat dissipation panel 21, or a region in which the mounting groove is formed on the first heat dissipation panel 21 may be connected to another region of the first heat dissipation panel 21 through assembly. The connection may be a detachable connection or a non-detachable connection.

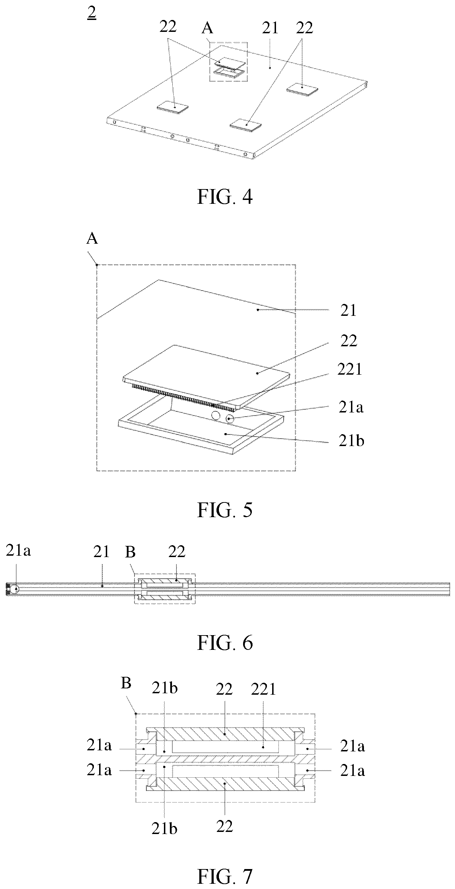

Refer to FIG. 2, FIG. 4, and FIG. 5. FIG. 5 is a partial enlarged view at a position A in FIG. 4. The second heat dissipation panel 22 may be a cold plate, and the second heat dissipation panel 22 has heat dissipation fins 221. The second heat dissipation panel 22 may cooperate with the mounting groove 21b on the first heat dissipation panel 21. The second heat dissipation panel 22 seals an opening of the mounting groove 21b to enclose a working medium cavity, and the working medium cavity is in communication with the runner 21a in the first heat dissipation panel 21. The heat dissipation fins 221 are accommodated in the working medium cavity, so that a contact area between the second heat dissipation panel 22 and the working medium can be increased, and heat dissipation performance can be improved. Therefore, the second heat dissipation panel 22 may be used to dissipate heat for the second component 13.

In an implementation, one or at least two second heat dissipation panels 22 may be disposed on only one side of the first heat dissipation panel 21. In another implementation, second heat dissipation panels 22 may be disposed on both sides of the first heat dissipation panel 21. The following describes in detail several connection structures between the first heat dissipation panel 21 and the second heat dissipation panel 22 by using examples.

Refer to FIG. 6 and FIG. 7. FIG. 7 is a partial enlarged schematic diagram at a position B in FIG. 6. Two second heat dissipation panels 22 are separately located on two sides of the first heat dissipation panel 21, and the two second heat dissipation panels 22 are fastened to the first heat dissipation panel 21. In an implementation, mounting grooves 21b are provided on both sides of the first heat dissipation panel 21, and the mounting grooves 21b on the two sides are independent of each other and are not in communication with each other. The two second heat dissipation panels 22 separately seal openings of the two mounting grooves 21b to form two independent working medium cavities. Two runners 21a are separately in communication with the two working medium cavities to supply the working medium. Based on FIG. 7, in another implementation, the two upper and lower runners 21a may alternatively be combined into a single runner, and the single runner forms two outlets on each side of the two second heat dissipation panels 22, so that the working medium can flow into or flow out of the two second heat dissipation panels 22 through the two outlets.

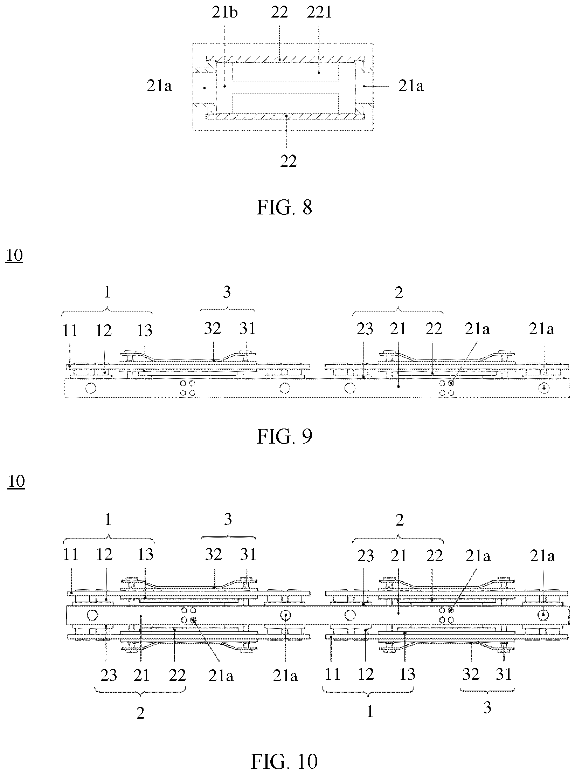

In another implementation, as shown in FIG. 8, the two second heat dissipation panels 22 are in communication with one mounting groove 21b. The mounting groove 21b penetrates the first heat dissipation panel 21, and forms openings on both sides of the first heat dissipation panel 21 (where the mounting groove 21b is equivalent to a through hole). The two second heat dissipation panels 22 are separately located on the two sides of the first heat dissipation panel 21, and the two second heat dissipation panels 22 each seal one opening of the mounting groove 21b. Therefore, the two second heat dissipation panels 22 and the mounting groove 21b on the first heat dissipation panel 21 jointly form a working medium cavity. Only one runner 21a in the first heat dissipation panel 21 is in communication with the working medium cavity, to take away heat of both the two second heat dissipation panels 22.

As shown in FIG. 2, the heat dissipation module 2 may further include a heat-conducting medium 23. The heat-conducting medium 23 may be disposed between the first heat dissipation panel 21 and the first component 12, or may be disposed between the second heat dissipation panel 22 and the second component 13. The heat-conducting medium 23 has excellent heat-conducting performance, and can effectively increase a heat exchange area between a heat dissipation panel and a component, to help improve heat-conducting efficiency to implement efficient heat dissipation. For example, the heat-conducting medium 23 between the first heat dissipation panel 21 and the first component 12 may be a thermal pad, and the heat-conducting medium 23 between the second heat dissipation panel 22 and the second component 13 may be a thermal interface material.

As shown in FIG. 1, FIG. 2, and FIG. 9, in this embodiment, the circuit board assembly 1 may be borne on the heat dissipation module 2. The circuit board 11 and the first heat dissipation panel 21 may be disposed in a stacked manner, and the first component 12 may be connected to the first heat dissipation panel 21 by using the heat-conducting medium 23. Both the second heat dissipation panel 22 and the circuit board 11 may be located on a same side of the first heat dissipation panel 21, and the second component 13 may be connected to the second heat dissipation panel 22 by using the heat-conducting medium 23. Therefore, the first component 12 with a low heat amount may be connected to the first heat dissipation panel 21 to implement heat dissipation, and the second component 13 with a high heat amount may dissipate heat through the second heat dissipation panel 22 and the first heat dissipation panel 21. In this way, corresponding heat dissipation can be performed on different components based on heat characteristics of the different components, to ensure heat dissipation performance of the entire circuit board assembly 1. Therefore, the solution of this embodiment can effectively dissipate heat for the circuit board assembly 1, and ensure reliability and experience of a product.

In this embodiment, based on a product requirement, the heat dissipation module 2 may bear one or at least two circuit board assemblies 1, and each circuit board assembly 1 may implement heat dissipation by using the foregoing heat dissipation design. It may be understood that, if only a first component 12 or a second component 13 is disposed on a circuit board of a circuit board assembly 1, the first component 12 dissipates heat through the first heat dissipation panel 21, or the second component 13 dissipates heat through a second heat dissipation panel 22 and the first heat dissipation panel 21.

As shown in FIG. 9, in an implementation, the circuit board assembly 1 is disposed on only one side of the first heat dissipation panel 21. Correspondingly, the second heat dissipation panel 22 may also be disposed only on a side that is of the first heat dissipation panel 21 and on which the circuit board assembly 1 is disposed.

It may be understood that, in this implementation, one or at least two circuit board assemblies 1 may be disposed on one side of the first heat dissipation panel 21. When at least two circuit board assemblies 1 are disposed, adjacent circuit board assemblies 1 may be separated. Correspondingly, one or at least two second heat dissipation panels 22 may be disposed on one side of the first heat dissipation panel 21. When at least two second heat dissipation panels 22 are disposed, adjacent second heat dissipation panels 22 may be separated, each second heat dissipation panel 22 may be correspondingly connected to one circuit board assembly 1, and one circuit board assembly 1 may be correspondingly connected to one or at least two second heat dissipation panels 22.

As shown in FIG. 10, in another implementation, one or at least two circuit board assemblies 1 are disposed on each of the two sides of the first heat dissipation panel 21, and second heat dissipation panels 22 are disposed on both sides of the first heat dissipation panel 21 and separately correspond to circuit board assemblies 1 on the two sides. When at least two circuit board assemblies 1 are disposed, adjacent circuit board assemblies 1 may be separated. Correspondingly, when at least two second heat dissipation panels 22 are disposed, adjacent second heat dissipation panels 22 may be separated, each second heat dissipation panel 22 may be correspondingly connected to one circuit board assembly 1, and one circuit board assembly 1 may be correspondingly connected to one or at least two second heat dissipation panels 22.

In the implementation in which circuit board assemblies 1 are disposed on both sides of the first heat dissipation panel 21, the second heat dissipation panels 22 on the two sides of the first heat dissipation panel 21 may be symmetrically distributed on the first heat dissipation panel 21, and every two symmetric working medium cavities are in communication with a same segment of runner 21a. In other words, when the working medium flows in a runner 21a between two second heat dissipation panels 22, heat of the two second heat dissipation panels 22 is taken away at the same time. In this design, both a structure design of a heat dissipation assembly and a layout of the runner 21a are simple, and a reuse rate of the runner 21a is high, so that an area of the first heat dissipation panel 21 can be effectively saved, and utilization of the first heat dissipation panel 21 can be improved.

In this embodiment, structures of the first heat dissipation panel 21 and the second heat dissipation panel 22 may be flexibly designed, to adapt to heights of the first component 12 and the second component 13, and ensure a reliable connection between a heat dissipation panel and a component.

The following describes several structures of the heat dissipation module 2 and connection structures between the heat dissipation module 2 and the circuit board assembly 1.

As shown in FIG. 3, in an implementation, the runner 21a in the first heat dissipation panel 21 may be embedded, in other words, the runner 21a is embedded inside the first heat dissipation panel 21, and the runner 21a is hidden below a surface of the first heat dissipation panel 21 and is not exposed. Interfaces may be formed at two ends of the runner 21a, so that the runner 21a is connected to external pipelines for the working medium to enter the runner 21a. For example, the runner 21a may be manufactured in manners such as drilling.

In this embodiment, distribution of the runner 21a may be designed based on a requirement. For example, the runner 21a may basically cover an entire region of the first heat dissipation panel 21. The runner 21a may be obtained by combining several segments of sub-runners 21a in series, in parallel, or in series and in parallel.

As shown in FIG. 3, the runner 21a may include a first primary runner 211a, a second primary runner 212a, and a plurality of branch runners 213a. The first primary runner 211a and the second primary runner 212a are separately runners on two sides of a substrate, and the branch runners 213a are runners in the middle of the substrate. In directions shown in FIG. 3, the first primary runner 211a and the second primary runner 212a are runners for horizontal flow, and the first primary runner 211a and the second primary runner 212a each have an inlet and an outlet, which are used to be connected to the working medium. The branch runners 213a are runners for vertical flow, there is a spacing between the plurality of branch runners 213a, and two ends of each branch runner 213a are separately connected to the first primary runner 211a and the second primary runner 212a, so that the plurality of branch runners 213a are connected in parallel.

As shown in FIG. 4 and FIG. 5, the mounting groove 21b may be provided on the first heat dissipation panel 21. Both a shape of the mounting groove 21b and a quantity of mounting grooves 21b may be designed based on a requirement. The mounting groove 21b is in communication with the runner 21a, and the runner 21a may penetrate groove walls of the mounting groove 21b. The second heat dissipation panel 22 may be fastened to the mounting groove 21b, and the second heat dissipation panel 22 seals the opening of the mounting groove 21b to form a sealed working medium cavity. A part of the second heat dissipation panel 22 may be exposed outside of the mounting groove, to be connected to the second component 13.

The first heat dissipation panel 21 in this implementation has a simple structure and good mass production performance. In addition, the heat dissipation module 2 in this implementation has a reliable structure, and can ensure good heat dissipation effect.

Different from the foregoing implementation, in another implementation, the runner 21a in the first heat dissipation panel 21 may be semi-embedded. Specifically, the first heat dissipation panel 21 may include a substrate and a cover plate, and both the substrate and the cover plate have approximately plate structures. A runner groove is provided on a surface of the substrate, and the runner groove forms an opening on the surface. The cover plate covers the substrate and seals the opening of the runner groove, and the cover plate and the runner groove jointly form the runner 21a in the first heat dissipation panel 21. Interfaces may be formed at two ends of the runner 21a, so that the runner 21a is connected to external pipelines for the working medium to enter the runner 21a. For example, the runner 21a may be manufactured in manners such as milling.

When the circuit board assembly 1 is disposed on only one side of the first heat dissipation panel 21, the runner groove is provided on only one side of the substrate. When circuit board assemblies 1 are disposed on both sides of the first heat dissipation panel 21, runner grooves are provided on both sides of the substrate.

In this implementation, distribution of the runner 21a may be similar to the distribution of the runner 21a in the previous implementation. Details are not described herein.

An advantage of this implementation lies in that a processing manner of the runner 21a in this implementation is simpler, and processing difficulty is greatly reduced. The runner groove only needs to be processed on the surface of the substrate in the milling manner or another manner, and the runner groove and the cover plate may cooperate to form the runner 21a. There are many processing manners that can be selected to process the runner groove, and a degree of freedom and flexibility of a shape of the runner groove are also very high. Therefore, the first heat dissipation panel 21 in this implementation has high adaptability and scalability, and can meet requirements of more working environments.

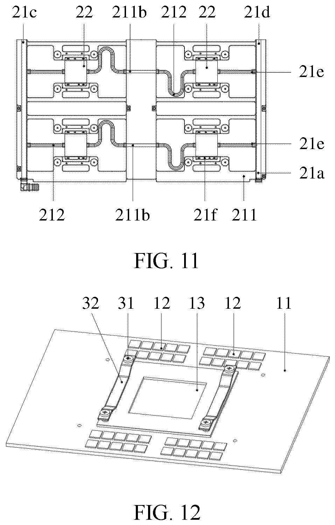

As shown in FIG. 11, in an implementation, the first heat dissipation panel 21 may include a substrate 211 and a runner pipe 212. The substrate 211 may have a partial hollow-out structure. A substrate runner 211b is embedded in a non-hollow-out region of the substrate 211, and the substrate runner 211b is hidden below a surface of the substrate 211 and is not exposed. Substrate runners 211b may be in direct communication with each other inside the substrate 211, or two separated substrate runners 211b may be in communication with each other by disposing a runner pipe 212 between the substrate runners 211b. The substrate runner 211b and the runner pipe 212 that are in communication with each other jointly form the runner 21a. The runner pipe 212 may be a pipe made of a metal material or a hose made of a non-metal material, and a specific type selection may be designed based on a requirement. A mounting groove 21f is further provided on the substrate 211, and the second heat dissipation panel 22 is in fastened connection to the mounting groove 21f on the substrate 211 in a cooperative manner, so that the second heat dissipation panel 22 is fastened to the substrate 211.

It should be noted that, in this implementation, as shown in FIG. 11, the runner 21a may include a first primary runner 21c, a second primary runner 21d, and a plurality of branch runners 21e. The first primary runner 21c and the second primary runner 21d are separately runners on two sides of the substrate 211, and the branch runners 21e are runners 21a in the middle of the substrate 211. In directions shown in FIG. 11, the first primary runner 21c and the second primary runner 21d are runners for vertical flow and are mainly formed by substrate runners 211b inside the substrate 211, and the first primary runner 21c and the second primary runner 21d each have an inlet and an outlet, which are used to be connected to the working medium. The branch runners 21e are runners 21a for horizontal flow, and may be formed by connecting a plurality of substrate runners 211b inside the substrate 211 and a plurality of runner pipes 212. Each branch runner 21e is connected in series to at least two second heat dissipation panels 22, and the branch runner 21e is in communication with a working medium cavity, so that the runner 21a is in communication with the working medium cavity to form a sealed circulation cavity. The plurality of branch runners 21e are separated, and two ends of each branch runner 21e are separately in communication with the first primary runner 21c and the second primary runner 21d, so that the plurality of branch runners 21e are connected in parallel.

The first heat dissipation panel 21 in the foregoing implementation has a split structure. Advantages of the first heat dissipation panel 21 are as follows: First, the substrate 211 has a hollow-out plate structure, so that a weight can be reduced and costs can be reduced. Second, because the substrate 211 is provided with a plurality of substrate runners 211b, the hollow-out structure can facilitate processing of the substrate runners 211b at different parts. This helps improve expandability of a shape of the substrate runner 211b and reduce processing difficulty, and further improve a yield of the substrate 211. In addition, the first heat dissipation panel 21 is assembled by splicing the substrate 211 and a plurality of runner pipes 212, so that a shape of the first heat dissipation panel 21 has a high degree of freedom, and the first heat dissipation panel 21 has high scalability and adaptability. Finally, if the runner pipe 212 of the first heat dissipation panel 21 is damaged, there is no need to replace the entire first heat dissipation panel 21, and only the partial runner pipe 212 needs to be replaced. This can greatly reduce maintenance costs and improve maintenance efficiency.

In an implementation, the first heat dissipation panel 21 may include a substrate and a runner pipe. Shapes and materials of the substrate and the runner pipe in this implementation may be similar to those of the substrate and the runner pipe in the previous implementation. A difference lies in that no substrate runner is provided in the substrate, but an accommodating groove is provided. The accommodating groove is provided on an outer surface of the substrate, the runner pipe may be embedded and fastened to the accommodating groove, and a plurality of runner pipes are in communication with each other to form the runner 21a. A mounting groove is further provided on the substrate, two sides of the second heat dissipation panel 22 are in fastened connection to the mounting groove of the substrate in a cooperative manner, and the second heat dissipation panel 22 is in fastened connection to the runner pipe in a cooperative manner, so that the runner 21a is in communication with a working medium cavity to form a sealed circulation cavity.

Composition of the runner 21a in this implementation is similar to composition of the runner 21a in the previous implementation, and may also include a first primary runner, a second primary runner, and a plurality of branch runners. Details are not described herein.

Advantages of this implementation are as follows: First, the substrate has a hollow-out plate structure, so that a weight can be reduced and costs can be reduced. Second, the runner 21a in this implementation is completely assembled by splicing the plurality of runner pipes, so that compared with the runner 21a in the previous implementation, a shape of the runner 21a in this implementation has a higher degree of freedom, the runner 21a in this implementation has higher scalability and adaptability, and maintenance is easier and more efficient.

In the foregoing assembly connections, the circuit board assembly 1 is distributed on an outer side of the heat dissipation module 2, and may be in fastened connection to the heat dissipation module 2 by using the connecting piece 3. The following describes a structure and a function of the connecting piece 3.

As shown in FIG. 1, FIG. 2, and FIG. 12, the connecting piece 3 may include a fixing piece 31 and an elastic piece 32. The fixing piece 31 is in fastened connection to the circuit board 11 and the first heat dissipation panel 21, and the fixing piece 31 may include a screw, another fastening piece, or the like. For example, a part of the fixing piece 31 may protrude from a surface that is of the circuit board 11 and that is away from the first heat dissipation panel 21, and the part of the fixing piece 31 may form an end cover (for example, a head of the screw) with a large area. The elastic piece 32 is installed between the fixing piece 31 and the circuit board. For example, one end of the elastic piece 32 may elastically abut against the end cover of the fixing piece 31, and the other end of the elastic piece 32 may elastically abut against the circuit board 11. The elastic piece 32 may enable a connection between the circuit board 11 and the first heat dissipation panel 21 to be a floating connection. The floating connection may allow a slight change of a spacing between the circuit board 11 and the first heat dissipation panel 21 (or the end cover of the fixing piece 31) (which is further described below). The elastic piece 32 may be a spring or a shrapnel.

As shown in FIG. 2, FIG. 9, and FIG. 12, in an implementation, the fixing piece 31 is a screw, and the elastic piece 32 is a shrapnel. For example, the elastic piece 32 may have a bent sheet structure, two ends of the elastic piece 32 and a middle segment of the elastic piece 32 each may have a straight structure, extension directions of the two ends of the elastic piece 32 are approximately the same as an extension direction of the middle segment of the elastic piece 32, and the two ends of the elastic piece 32 are tilted relative to the middle segment of the elastic piece 32, so that the two ends of the elastic piece 32 and the middle segment of the elastic piece 32 are not in a same plane. If the two ends of the elastic piece 32 are under pressure, the bent structure of the elastic piece 32 can provide a resilient force for the elastic piece 32 to restore elastic deformation. As shown in FIG. 2, fixing pieces 31 are disposed on a periphery of the circuit board 11, and every two fixing pieces 31 are connected to one elastic piece 32. A screw rod part of the fixing piece 31 is in threaded connection to the circuit board 11 and the first heat dissipation panel 21, and there is a specific spacing between a head of the fixing piece 31 (that is, a head of a screw) and the circuit board 11. Two ends of the elastic piece 32 are separately sleeved on peripheries of screw rods between heads of the two fixing pieces 31 and the circuit board 11, and separately abut against the heads of the two fixing pieces 31. A middle segment of the elastic piece 32 may abut against the circuit board 11, so that the circuit board 11 and the first heat dissipation panel 21 are in floating connection.

In another implementation, in the connecting piece 3, the fixing piece 31 is a screw, and the elastic piece 32 is a spring. Fixing pieces 31 are disposed on a periphery of the circuit board 11, each fixing piece 31 has a corresponding spring, a screw rod part of the fixing piece 31 is in threaded connection to the circuit board 11 and the first heat dissipation panel 21, and there is a specific spacing between a head of the fixing piece 31 and the circuit board 11. The spring is sleeved on a screw rod between the head of the fixing piece 31 and the circuit board 11, one end of the spring elastically abuts against the head of the fixing piece 31, and the other end of the spring elastically abuts against the circuit board 11, so that the circuit board 11 and the first heat dissipation panel 21 are in floating connection.

Due to a manufacturing error, heights of components of a same specification have a dimension tolerance within a specific range. As a result, even in circuit board assemblies of a same batch, heights of components of a same specification on circuit boards are different. In a process of producing electronic assemblies in batches, the circuit board assembly 1 is usually assembled to the first heat dissipation panel 21 by using a unified assembly process parameter (for example, a quantity of rotations of a screw during screw fastening). If the circuit board assembly 1 is connected to the first heat dissipation panel 21 at a nonadjustable spacing, a large amount of extrusion may be generated between a component with a large height and the first heat dissipation panel 21 or the second heat dissipation panel 22 (where the component is against the first heat dissipation panel 21 or the second heat dissipation panel 22), and the component or the entire circuit board assembly 1 may be damaged. Consequently, an assembly yield is reduced.

In view of this, in this implementation, the elastic piece 32 is disposed between the fixing piece 31 and the circuit board, so that the circuit board assembly 1 is in floating connection to the first heat dissipation panel 21, and a spacing between the circuit board assembly 1 and the first heat dissipation panel 21 may be slightly adjusted in an assembly process. For example, if a height of a component is large, the circuit board 11 may move away from the first heat dissipation panel 21 and compress the elastic piece 32. If a height of a component is small, the elastic piece 32 may abut against the circuit board, so that the circuit board moves toward the first heat dissipation panel 21. Therefore, after assembly is completed, an appropriate spacing may be maintained between the circuit board 11 and the first heat dissipation panel 21, and the component is protected from being squeezed. Therefore, the floating connection in this implementation can provide a specific installation tolerance, so that the spacing between the circuit board and the first heat dissipation panel 21 can be adaptively adjusted in the assembly process, to adapt to components with different heights. This can greatly avoid damage to the components in an installation process, effectively improve a product yield, and reduce production and manufacturing costs.

In a conventional electronic device, circuit board assemblies 1 that are disposed in a stacked manner are usually designed to increase a component integration level, so as to implement a high-density layout of components. However, for a circuit board assembly 1 at each layer, a heat dissipation module 2 correspondingly connected to the circuit board assembly 1 is disposed, which causes a complex structure of an electronic assembly, a large quantity of complex runners for a working medium, and a large total thickness of the electronic assembly.

In the solutions of this embodiment of this application, circuit board assemblies 1 and second heat dissipation panels 22 are disposed on two opposite sides of the first heat dissipation panel 21, to implement stacked disposition of the circuit board assemblies 1, and therefore ensure a high-density layout of components to meet a function requirement of the product. In addition, in the electronic assembly in this embodiment, only one layer of first heat dissipation panel 21 needs to be disposed, and the first heat dissipation panel 21 and the second heat dissipation panels 22 on the two sides of the first heat dissipation panel 21 are used to dissipate heat for the components on the two sides of the first heat dissipation panel 21. In this design, a structure of the electronic assembly is simple, and a total thickness of the electronic assembly is small, which are conducive to implementing lightness and thinness of the electronic device. In addition, because the second heat dissipation panels 22 on the two sides of the first heat dissipation panel 21 are in communication with the first heat dissipation panel 21, a layout of the working medium runner 21a of the heat dissipation module 2 is simple, so that mass production performance and reliability of the product are improved, and costs are reduced.

In this embodiment of this application, in a scenario in which circuit board assemblies 1 are disposed on two opposite sides of the heat dissipation module 2 and circuit boards 11 on the two sides are fastened to the first heat dissipation panel 21 in the middle, the circuit board 11 can float relative to the first heat dissipation panel 21 to adapt to the scenario.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An electronic assembly, comprising:
a first heat dissipation panel, a second heat dissipation panel, and a first circuit board assembly, wherein
the first heat dissipation panel is provided with a runner;
the second heat dissipation panel is fastened to the first heat dissipation panel, and encloses a working medium cavity with the first heat dissipation panel, wherein the working medium cavity is in communication with the runner; and
the first circuit board assembly comprises a first circuit board, a first component, and a second component, the first component and the second component are both disposed on a same side of the first circuit board, the first circuit board and the first heat dissipation panel are disposed in a stacked manner, the first component is connected to the first heat dissipation panel, and the second component is connected to the second heat dissipation panel.

2. The electronic assembly according to claim 1, wherein
the runner is embedded inside the first heat dissipation panel.

3. The electronic assembly according to claim 1, wherein
the first heat dissipation panel comprises a substrate and a cover plate, a surface of the substrate is provided with a runner groove, the cover plate is connected to a side that is of the substrate and that is provided with the runner groove, and the cover plate covers the substrate and seals the runner groove to form the runner.

4. The electronic assembly according to claim 1, wherein
the first heat dissipation panel comprises a substrate and a runner pipe, the substrate is provided with an accommodating groove, the runner pipe is fastened to the accommodating groove, and the runner pipe is used as the runner.

5. The electronic assembly according to claim 1, wherein
the first heat dissipation panel comprises a substrate and a runner pipe, a substrate runner is embedded in the substrate, the runner pipe is installed on the substrate and is in communication with the substrate runner, and the runner pipe and the substrate runner jointly form the runner.

6. The electronic assembly according to any one of claims 1 to 5, wherein
the first heat dissipation panel is provided with a mounting groove, and the mounting groove is in communication with the runner; and the second heat dissipation panel is mounted in the mounting groove, and seals an opening of the mounting groove to enclose the working medium cavity with the first heat dissipation panel.

7. The electronic assembly according to any one of claims 1 to 6, wherein
the runner comprises a first primary runner, a second primary runner, and a plurality of branch runners, the first primary runner and the second primary runner are arranged in parallel and are separated, each branch runner is in communication with the first primary runner and the second primary runner, the plurality of branch runners are separated, and the plurality of branch runners are connected in parallel.

8. The electronic assembly according to claim 7, wherein
the electronic assembly comprises a plurality of second heat dissipation panels, and at least one branch runner is connected to at least two second heat dissipation panels in series.

9. The electronic assembly according to any one of claims 1 to 8, wherein
circuit board assemblies and second heat dissipation panels are disposed on two opposite sides of the first heat dissipation panel; and in a circuit board assembly on a same side of the first heat dissipation panel, a first component is connected to the first heat dissipation panel, and a second component is connected to a second heat dissipation panel on the same side.

10. The electronic assembly according to any one of claims 1 to 9, wherein
the electronic assembly further comprises a fixing piece and an elastic piece; and
the fixing piece is connected to the first circuit board and the first heat dissipation panel, the elastic piece is located between the fixing piece and the first circuit board, and the elastic piece elastically abuts against both the fixing piece and the circuit board.

11. The electronic assembly according to any one of claims 1 to 10, wherein
a part of the first heat dissipation panel is hollow-out, and the second heat dissipation panel is fastened to a non-hollow-out region of the first heat dissipation panel.

12. An electronic device, comprising:
a working medium and the electronic assembly according to any one of claims 1 to 11, wherein the working medium flows in the runner and the working medium cavity.
